# EUROPÄISCHE PATENTSCHRIFT

(11) **EP 1 342 301 B1**
(45) Veröffentlichungstag und Bekanntmachung des Hinweises auf die Patenterteilung: **14.02.2007**
(21) Anmeldenummer: 01990290.7
(22) Anmeldetag: 12.12.2001
(51) Int. Cl.: H01S 5/16

(54) **HALBLEITERLASER MIT LATERALER STROMFÜHRUNG UND VERFAHREN ZU DESSEN HERSTELLUNG**
SEMICONDUCTOR LASER WITH LATERAL CURRENT CONDUCTION AND METHOD FOR PRODUCING THE SAME
LASER A SEMI-CONDUCTEURS A CONDUCTION DE COURANT LATERALE ET SON PROCEDE DE PRODUCTION

(30) Priorität: 12.12.2000 DE 10061701
(43) Veröffentlichungstag der Anmeldung: 10.09.2003
(73) Patentinhaber: Osram Opto Semiconductors GmbH, 93049 Regensburg (DE)
(72) Erfinder: ACKLIN, Bruno, Palo Alto, CA 94306 (US); BEHRINGER, Martin, 93051 Regensburg (DE); EBELING, Karl, 89075 Ulm (DE); HANKE, Christian, 81737 München (DE); HEERLEIN, Jörg, 93051 Regensburg (DE); KORTE, Lutz, 83620 Feldkirchen-Westerham (DE); LUFT, Johann, 93195 Wolfsegg (DE); SCHLERETH, Karl-Heinz, 93133 Burglengenfeld (DE); SPÄTH, Werner, 83607 Holzkirchen (DE); SPIKA, Zeljko, 93047 Regensburg (DE)
(74) Vertreter: Epping - Hermann - Fischer
(86) Internationale Anmeldenummer: PCT/DE2001/004687
(87) Internationale Veröffentlichungsnummer: WO 2002/049168

(56) Entgegenhaltungen:
- EP-A- 0 472 212
- EP-A- 0 674 368
- US-A- 5 550 081
- MARANOWSKI S A ET AL: "NATIVE-OXIDE DEFINED IN0.5(ALXGA1-X)0.5P QUANTUM WELL HETEROSTRUCTURE WINDOW LASERS (660 NM)" APPLIED PHYSICS LETTERS, AMERICAN INSTITUTE OF PHYSICS. NEW YORK, US, Bd. 61, Nr. 14, 5. Oktober 1992 (1992-10-05), Seiten 1688-1690, XP000307512 ISSN: 0003-6951
- MARANOWSKI S A ET AL: "AIXGA1-XAS-GAAS-INYGAU-Y AS QUANTUM WELL HETEROSTRUCTURE LASERS WITH NATIVE OXIDE CURRENT-BLOCKING WINDOWS FORMED ON METALLIZED DEVICES" APPLIED PHYSICS LETTERS, AMERICAN INSTITUTE OF PHYSICS. NEW YORK, US, Bd. 64, Nr. 16, 18. April 1994 (1994-04-18), Seiten 2151-2153, XP000440706 ISSN: 0003-6951
- CARACCI S J ET AL: "HIGH-PERFORMANCE PLANAR NATIVE-OXIDE BURIED-MESA INDEX-GUIDED ALGAAS-GAAS QUANTUM WELL HETEROSTRUCTURE LASERS" APPLIED PHYSICS LETTERS, AMERICAN INSTITUTE OF PHYSICS. NEW YORK, US, Bd. 61, Nr. 3, 20. Juli 1992 (1992-07-20), Seiten 321-323, XP000287679 ISSN: 0003-6951

## Beschreibung

Die Erfindung bezieht sich auf einen Halbleiterlaser mit lateraler Stromführung gemäß dem Oberbegriff des Patentanspruchs 1 sowie ein Verfahren zu dessen Herstellung nach dem Oberbegriff des Patentanspruchs 11.

Halbleiterlaser mit lateraler Stromführung sind beispielsweise aus IEEE, Journal of Selected Topics in Quantum Electronics, Vol.5 No.3 May/June 1999 bekannt. Gezeigt ist hier ein kantenemittierender MCRW-Laser (metal clad ridge waveguide laser) auf GaAs-Basis, in dessen Halbleiterkörper eine Stromführungsschicht ausgebildet ist. Diese Stromführungsschicht besteht aus einer AlAs-Schicht mit zwei streifenartigen oxidierten Bereichen, die parallel zur Strahlungspropagationsrichtung im Laser bzw. zur Emissionsrichtung verlaufen und symmetrisch zur Mittelebene des Halbleiterlasers angeordnet sind. Diese Anordnung bewirkt einerseits eine Indexführung des Strahlungsfeldes und andererseits eine Konzentration des Pumpstroms auf den Innenbereich der aktiven Schicht.

In Maranowski et al. Applied Physics Letters, Bd. 61 Nr.14,(1992-10-05),S. 1688-1690 und Maranowski et al. Applied Physics Letters, Bd. 64 Nr.16,(1994-04-18), S.2151-2153 werden sogenannte Halbleiterfensterlaser und in Caracci S. et al. Applied Physics Letters, Bd. 61 Nr.3,(1992-07-20),S. 321-323 ein Halbleiterlaser mit streifenförmigen Oxidationsbereichen beschrieben. Die dort beschriebenen Halbleiterlaser weisen, in einem Halbleiterkörper mindestens einen streifenförmigen, quer zur einer Resonatorachse verlaufenden Widerstandsbereich auf, dessen spezifischer Flächenwiderstand gegenüber den an den Widerstandsbereich angrenzenden Bereichen der Stromführungsschicht zumindest in Teilbereichen erhöht ist.

Bei kantenemittierenden Lasern können im Betrieb in der Nähe der Resonatorspiegel vermehrt nichtstrahlende Rekombinationsprozesse auftreten. Die hiervon betroffenen Anteile des Pumpstroms tragen nicht zur Erzeugung der für den Laserbetrieb erforderlichen Besetzungsinversion bei, sondern führen durch Generation von Phononen zur Erwärmung der spiegelnahen Bereiche des Halbleiterkörpers. Dies verstärkt die Degradation der Spiegel und verringert damit die Lebensdauer des Halbleiterlasers. Weiterhin wird die maximal erreichbare optische Ausgangsleistung des Lasers durch nichtstrahlende Rekombinationsprozesse limitiert.

Ferner weisen kantenemittierende Halbleiterlaser der eingangs genannten Art in der Regel nur eine schwach ausgepräge Modenselektivität auf. Daher können insbesondere bei großen Pumpleistungen unerwünschte höhere Moden leicht anschwingen.

Aufgabe der Erfindung ist es, einen Halbleiterlaser mit verbesserter Stromführung zu schaffen, der zugleich technisch einfach herstellbar ist. Weiterhin ist es Aufgabe der Erfindung, ein Herstellungsverfahren hierfür anzugeben.

Diese Aufgabe wird durch einen Halbleiterlaser nach Patentanspruch 1 bzw. ein Herstellungsverfahren nach Patentanspruch 11 gelöst. Vorteilhafte Weiterbildungen der Erfindung sind Gegenstand der Unteransprüche 2 bis 10 und 12 bis 17.

Erfindungsgemäß ist vorgesehen, den Halbleiterkörper nach Art eines kantenemittierenden Halbleiterlasers mit einer aktiven Schicht und einer dazu parallelen Resonatorachse, einer ersten und einer zweiten, zur Resonatorachse im wesentlichen senkrecht angeordneten Spiegelfläche sowie mit mindestens einer sich von der ersten zur zweiten Spiegelfläche erstreckenden Stromführungsschicht auszubilden. Die aktive Schicht und die Stromführungsschicht sind zwischen einer ersten Hauptfläche des Halbleiterkörpers und einer der ersten Hauptfläche gegenüber liegenden zweiten Hauptfläche des Halbleiterkörpers angeordnet, die vorzugsweise jeweils mit einer Kontaktfläche versehen sind.

Die Stromführungsschicht weist mindestens einen streifenfömigen Widerstandsbereich auf, dessen spezifischer Flächenwiderstand gegenüber dem spezifischen Flächenwiderstand des an den Widerstandsbereich angrenzendenden Bereichs der Stromführungsschicht zumindest in Teilbereichen erhöht ist. Zusätzlich ist der spezifische Flächenwiderstand des mindestens einen Widerstandsbereichs wiederum in einem ersten Teilbereich geringer als in einem zweiten Teilbereich, wobei der erste Teilbereich einen geringeren Abstand zur Resonatorachse aufweist als der zweite Teilbereich. Unter dem spezifischen Flächenwiderstand ist der Widerstand der Stromführungsschicht, bezogen auf eine Einheitsfläche, in Richtung der Flächennormale zu verstehen.

Vorzugsweise ist an einer der beiden Spiegelflächen ein Widerstandsbereich oder an beiden Spiegelflächen jeweils ein Widerstandbereich angrenzend ausgebildet. Im Betrieb wird mit Vorteil aufgrund des erhöhten elektrischen Widerstands der Stromführungsschicht in der Nähe der Spiegelebenen der Stromfluß vermindert oder unterdrückt. Dadurch werden die in Spiegelnähe üblicherweise vermehrt auftretenden nichtstrahlenden Prozesse verringert und so eine Aufheizung der Spiegelflächen und eine damit verbundene schnellere Alterung vermindert. Ein weiterer Vorteil der Erfindung besteht darin, daß durch Verminderung der nichtstrahlenden Prozesse die interne Quanteneffizienz des Lasers gesteigert wird.

Bei einer weiteren vorteilhaften Ausführungsform der Erfindung ist ein streifenartige Widerstandsbereich in der Stromführungsschicht so ausgebildet, daß der spezifische Flächenwiderstand vor allem in fern von der Resonatorachse liegendenden Teilbereichen erhöht ist. In der Nähe der Resonatorachse ist der Flächenwiderstand vorzugsweise unverändert gegenüber den angrenzenden Bereichen der Stromführungsschicht. Durch diese Struktur wird die Laserverstärkung auf die Resonatorachse konzentriert und so eine Modenblende geschaffen, die die Modenselektivität des Lasers vorteilhaft erhöht.

Bevorzugt ist der spezifische Flächenwiderstand des oder der Widerstandsbereiche in der Stromführungsschicht so weit erhöht, daß diese Bereiche einen elektrischen Isolator darstellen und damit eine effiziente Unterdrückung des Stromflusses in diesen Bereichen gewährleistet ist.

Weiter bevorzugt sind die aktive Schicht und die Stromführungsschicht zueinander eng benachbart angeordnet. Dies verhindert, daß Pumstromanteile durch Stromaufweitung die Widerstandbereiche der Stromführungsschicht unterwandern.

Bei spiegelnahen Widerstandsbereichen werden so besonders die nahe an der aktiven Schicht liegenden Bereiche der Spiegel vor Degradation geschützt, an denen die Hauptanteile des Strahlungsfeldes reflektiert oder ausgekoppelt werden und die daher für die Leistungsfähigkeit des Lasers von besonderer Bedeutung sind.

Bei einer vorteilhaften Weiterbildung der Erfindung enthalten die Widerstandsbereiche der Stromführungsschicht Oxidverbindungen des Materials, aus dem die Stromführungsschicht gebildet ist oder davon abgeleitete Oxidverbindungen. Solche Oxidschichtbereiche zeichnen sich durch gute elektrische Isolationseigenschaften aus und sind technisch ohne großen Aufwand herstellbar.

Die Erfindung ist bezüglich des Halbleitermaterials keinen prinzipiellen Beschränkungen unterworfen. Sie eignet sich insbesondere für Halbleitersysteme auf der Basis von GaAs oder InP, insbesondere für InGaAs, AlGaAs, InGaAlAs, InGaP, InGaAsP oder InGaAlP.

Ein erfindungsgemäßes Herstellungsverfahren beginnt mit der Herstellung einer der späteren Laserstruktur entsprechenden Halbleiterschichtenfolge nach einem üblichen Verfahren. Beispielsweise können die Halbleiterschichten epitaktisch auf ein geeignetes Substrat aufgewachsen werden. Bei diesem Schritt wird auch die Stromführungsschicht angelegt, die allerdings zunächst einen homogenen Flächenwiderstand aufweist.

Im nächsten Schritt wird die Halbleiterschichtenfolge kammartig in Streifen strukturiert.

Danach schließt sich eine partielle, laterale Oxidation der Stromführungsschicht zur Ausbildung der streifenförmigen Widerstandsbereiche sowie die Vereinzelung der kammartigen Halbleiterstreifen in einzelne Halbleiterkörper an. Bei der partiellen lateralen Oxidation wird ein Teilbereich der Stromführungsschicht oxidiert, wobei dieser Teilbereich bei der Oxidation in der Ebene der Stromführungsschicht von der Seitenfläche in den Halbleiterkörper hinein, also in lateraler Richtung anwächst.

Bei der Ausbildung spiegelnaher Widerstandsbereiche werden bei diesem Verfahren mit Vorteil keine Veränderungen an den Spiegelflächen selbst vorgenommen, die die thermische Ankoppung der Spiegel an den Halbleiterkörper verschlechtern bzw. die Aufheizung der Spiegel im Betrieb fördern könnten.

Bei einer bevorzugten Ausgestaltung der Erfindung findet die partielle laterale Oxidation der Stromführungsschicht vor der Vereinzelung statt. Mit Vorteil ist so die Oxidation im Waferverbund möglich, wodurch der Herstellungsaufwand reduziert wird. Vorzugsweise ist dabei die Wachstumsrichtung der Oxidbereiche bei der partiellen lateralen Oxidation von beiden Seitenflächen der Halbleiterstreifen zur Mitte der Stromführungsschicht hin gerichtet.

Eine weitere Ausgestaltung der Erfindung besteht darin, die partielle laterale Oxidation nach der Vereinzelung durchzuführen. Von besonderem Vorteil ist diese Ausgestaltung der Erfindung bei Breitstreifenlasern, die eine lateral weit ausgedehnte aktive Schicht aufweisen. Spiegelnahe Widerstandsbereiche der Stromführungsschicht können so auch von der Spiegelseite her oxidiert werden, wodurch ein zu tiefes Eindringen der oxidierten Bereiche in den Halbleiterkörper vermieden werden kann.

Bei einer bevorzugten Weiterbildung der Erfindung wird das Herstellungsverfahren fortgesetzt mit der Ausbildung der Kontaktflächen auf den entsprechenden Hauptflächen des so gebildeten Halbleiterkörpers.

In einem weiteren Schritt können die Spiegelflächen ein- oder beidseitig mit einer optischen Vergütung versehen werden, beispielsweise mit einer Schicht zur Verbesserung der Reflexionseigenschaften oder einer anderweitigen Schutzschicht.

Weitere Merkmale, Vorteile und Zweckmäßigkeiten der Erfindung ergeben sich aus der nachfolgenden Beschreibung von vier Ausführungsbeispielen in Verbindung mit den Figuren 1 bis 4.

Es zeigen:
- Figur 1: eine perspektivische Teilschnittansicht und eine zugehörige Schnittansicht eines ersten Ausführungsbeispiels eines erfindungsgemäßen Halbleiterlasers,
- Figur 2: eine schematische Schnittansicht eines zweiten Ausführungsbeispiels eines erfindungsgemäßen Halbleiterlasers,
- Figur 3: eine schematische Darstellung eines ersten Ausführungsbeispiels eines erfindungsgemäßen Herstellungsverfahrens und
- Figur 4: eine schematische Darstellung eines Zwischenschritts bei dem ersten und einem zweiten Ausführungsbeispiel eines erfindungsgemäßen Herstellungsverfahrens.

Gleiche oder gleich wirkende Elemente sind hierbei mit denselben Bezugszeichen versehen.

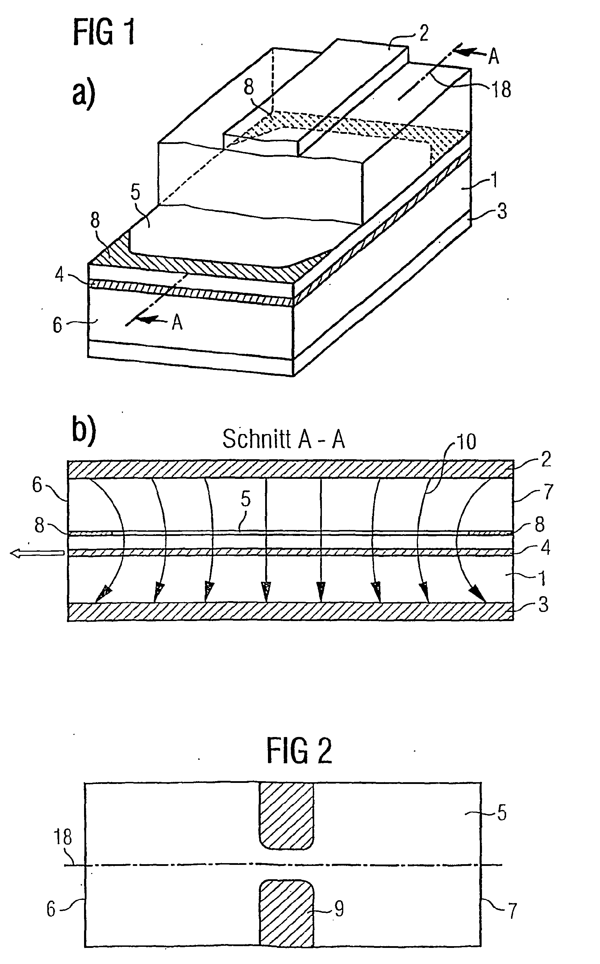

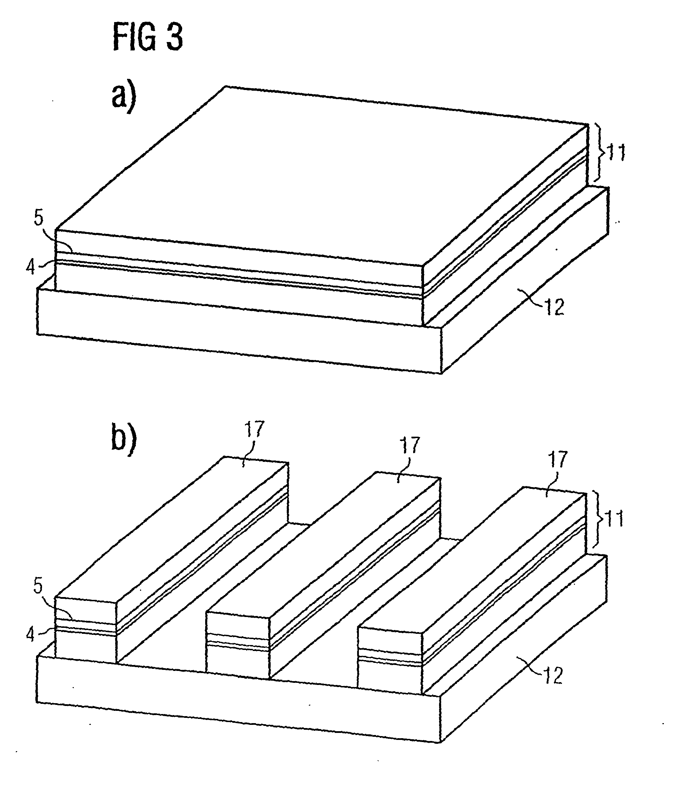

Der in Figur 1a gezeigte Halbleiterlaser weist einen Halbleiterkörper 1 auf, der an zwei gegenüber liegenden Hauptflächen mit einer ersten Kontaktfläche 2 und einer zweiten Kontaktfläche 3 versehen ist. Dazwischen ist parallel zu den Hauptflächen eine aktive Schicht 4 ausgebildet. In der aktiven Schicht 4 wird im Betrieb zwischen Valenz- und Leitungsband eine Besetzungsinversion erzeugt, die der Strahlungserzeugung bzw. -verstärkung durch stimulierte Emission dient.

Als Halbleitermaterial wird das Materialsystem InGaAs/AlGaAs verwendet, wobei die aktive Schicht 4 als Quantentopfstruktur (quantum well) ausgebildet ist. Zwischen der aktiven Schicht 4 und der Kontaktfläche 2 ist parallel zur aktiven Schicht 4 eine Stromführungsschicht 5 in Form einer AlₓGa₁₋ₓAs-Schicht (0≤x≤1, vorzugsweise 0,9≤x≤1,0) angeordnet.

Die Stirnseite und die Rückseite des Halbleiterkörpers bilden die Endspiegel 6,7 des Laserresonators. An die Spiegelflächen 6,7 angrenzend ist jeweils ein Widerstandsbereich 8 ausgebildet, der Aluminiumoxid enthält und elektrisch isolierend ist, d.h. eine vernachlässigbare elektrische Leitfähigkeit aufweist.

In Figur 1b ist die Wirkung der isolierenden Bereiche 8 in einer Schnittansicht dargestellt. Die Schnittebene steht dabei senkrecht auf den Halbleiterschichten und verläuft mittig durch den Halbleiterkörper entlang der Resonatorachse 18.

Im Betrieb wird ein Pumpstrom 10 über die Kontaktflächen 2 bzw. 3 in den Halbleiterkörper injiziert und fließt im wesentlichen senkrecht zur aktiven Schichtebene 4 durch den Halbleiterkörper. Über einen weiten Bereich in der Mitte der Schnittansicht fließt der Pumpstrom auf direktem Weg von der Kontaktfläche 2 zur Kontaktfläche 3. In der Nähe der Spiegelebene 6 und 7 wird ein solcher Stromfluß durch die isolierenden Widerstandsbereiche 8 verhindert, so daß der Pumpstrom 10 in Richtung des Mittelbereichs zusammen gedrängt und von den Spiegelebenen ferngehalten wird. Damit werden die in Spiegelnähe erhöht auftretenden strahlungslosen Rekombinationsprozesse unterdrückt und die damit verbundene Aufheizung der Spiegelflächen verhindert.

In Figur 2 ist die Aufsicht auf die Stromführungsschicht eines weiteren Ausführungsbeispiels der Erfindung gezeigt. Der generelle Aufbau entspricht dem in Figur 1 gezeigten Halbleiterlaser. Im Unterschied hierzu ist mittig zwischen den beiden Spiegelflächen 6 und 7 ein streifenförmiger, senkrecht zur Resonatorachse 18 verlaufender Widerstandsbereich 9 gebildet, der in den schraffiert dargestellten Teilbereichen oxidiert und somit elektrisch isolierend ist. Ein die Resonatorachse 18 umgebender Teilbereich wurde hiervon ausgespart.

Innerhalb des Widerstandsbereichs 9 wird der Pumpstrom und somit auch die Laserverstärkung lokal auf die Resonatorachse 18 konzentriert und damit eine aktive Modenblende gebildet. Zudem wird durch den Brechungsindexunterschied zwischen den oxidierten und den nicht oxidierten Bereichen der Stromführungsschicht 5 auch eine passive Modenblende gebildet.

Durch diese Modenblendenstruktur erfährt die in der Nähe der Resonatorachse propagierende Grundmode eine deutlich größere Verstärkung als höhere Moden mit einer größeren lateralen Ausdehnung. Die Modenselektivität des Halbleiterlasers wird so vorteilhaft erhöht.

Weitergehend können zur Modenselektion auch durchgehende streifenförmige Widerstandsbereiche ausgebildet sein, durch die beispielsweise eine Selektion bestimmter logitudinaler Moden möglich ist. Selbstverständlich können auch einzelne Aspekte der gezeigten Ausführungsbeispiele kombiniert werden.

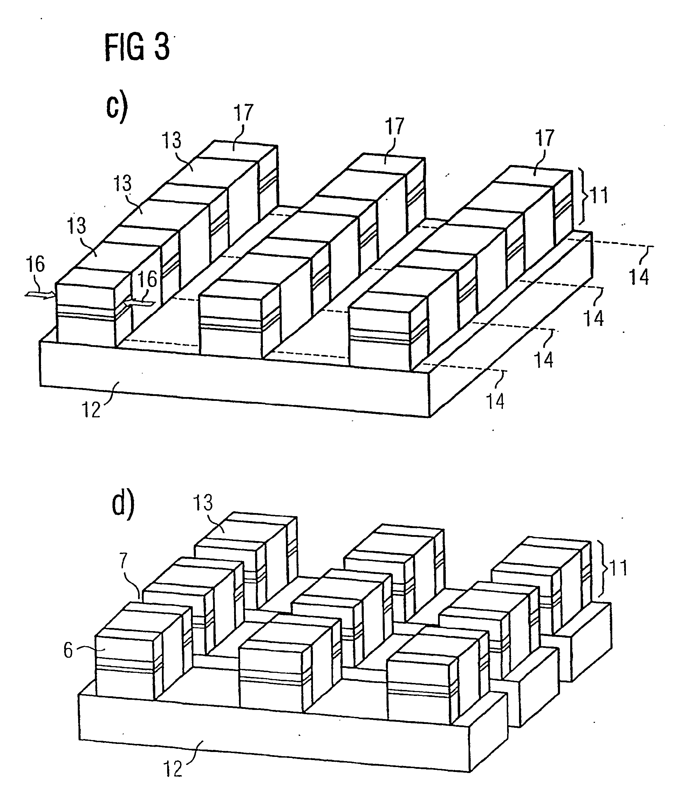

Das in Figur 3 anhand von vier Zwischenschritten a) bis d) schematisch dargestellte Herstellungsverfahren beginnt mit der epitaktischen Herstellung der Halbleiterschichtenfolge 11 auf einem Epitaxiesubstrat 12, Figur 3a. Die epitaktische Herstellung erfolgt nach den üblichen, dem Fachmann bekannten Verfahren.

Dabei wird in der Halbleiterschichtenfolge 11 die aktive Schicht 4 ausgebildet und die Stromführungsschicht in Form einer homogenen, oxidierbaren Halbleiterschicht angelegt. Im Fall des AlGaAs/InGaAs-Materialsystems eignet sich hierfür beispielsweise eine AlₓGa₁₋ₓAs-Schicht (0≤x≤1) mit einer Dicke zwischen 5 und 100 nm.

Im.nächsten Schritt, Figur 3b, wird die Halbleiterschichtenfolge 11 in kammartige Halbleiterstreifen 17 strukturiert. Die Streifenbreite liegt dabei vorzugsweise zwischen 1µm und 400µm. Diese Strukturierung kann beispielsweise durch Grabenätzung erfolgen.

In einem weiteren Schritt, Figur 3c, erfolgt die partielle laterale Oxidation derjenigen Bereiche, die bei den vereinzelten Halbleiterkörpern die Widerstandsbereiche 8 bzw. 9 bilden.

Dazu wird zunächst eine geeignete Maske 13, beispielsweise eine Oxid- oder Nitridmaske auf den Halbleiterstreifen 17 aufgebracht, die das darunter liegende Material vor dem Oxidangriff schützt. Die den isolierenden Bereichen 8 bzw. 9 entsprechenden Flankenbereiche der Halbleiterstreifen 17 bleiben unbedeckt.

Danach werden die Halbleiterstreifen 17 einem geeigneten Oxidationsmittel ausgesetzt. Für AlGaAs-Halbleitersysteme kann hierfür eine Wasserdampfatmosphäre bei erhöhter Temperatur verwendet werden. In der Stromführungsschicht wachsen dabei aluminiumoxidhaltige Zonen während der Einwirkungsdauer des Oxidationsmittels in der in Figur 3c mit Pfeilen 16 markierten Richtung von den jeweiligen Flanken der Halbleiterstreifen 17 zur Streifenmitte hin.

Zur Ausbildung zusammenhängender Widerstandsbereiche wird die Oxidation so lange durchgeführt, bis die sich von beiden Flanken her ausbreitenden Oxidzonen eine durchgehende Fläche bilden. Zur Herstellung von Widerstandsbereichen 9 gemäß Figur 2 wird alternativ die Oxidation früher beendet, so daß sich die von beiden Flanken her ausbreitenden Oxidzonen nicht berühren.

Nach diesem Schritt werden die Halbleiterstreifen 17 durch Brechen in vereinzelt, Figur 3d. Dargestellt ist Figur 3d nur der erste Vereinzelungsschritt, bei dem die Bruchkanten 14 quer zu den Halbleiterstreifen 17 verlaufen. In einem weiteren Schritt können dann die jeweils auf einem Streifen des Substrats 12 angeordneten Halbleiterkörper vereinzelt werden.

Die Bruchkanten 14 sind bei diesem ersten Vereinzelungsschritt so angeordnet, daß sie jeweils durch die Oxidzonen hindurch verlaufen. Die so gebildeten Bruchflächen (Spaltflächen) bilden die Spiegelflächen 6 und 7 des Halbleiterlasers. Durch die Anordnung der Bruchkanten 14 innerhalb der Oxidzonen grenzt in der Stromführungsschicht 5 jeweils ein oxidierter, elektrisch isolierender Widerstandsbereich an die Spiegelflächen und verhindert im Betrieb einen Stromfluß in Spiegelnähe.

Zur Herstellung von Widerstandsbereichen 9 gemäß Figur 2 werden die Bruchkanten 14 außerhalb der Oxidzonen angeordnet oder zwischen den Bruchkanten 14 weitere Oxidzonen ausgebildet.

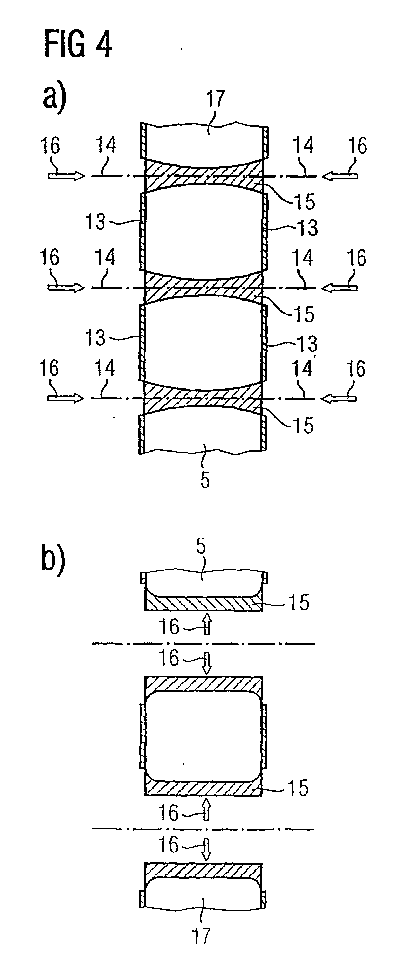

In Figur 4 ist in zwei Alternativen ein Schnitt durch die Halbleiterstreifen 17 in der Ebene der Stromführungsschicht nach der partiellen lateralen Oxidation dargestellt. Bei Figur 4a erfolgte die partielle laterale Oxidation vor der Vereinzelung, bei Figur 4b nach der Vereinzelung.

Bei der partiellen lateralen Oxidation vor der Vereinzelung, Figur 4a, wachsen die Oxidbereiche 15 im wesentlichen in Richtung der Pfeile 16 von den Seitenflächen zur Mittelachse der Halbleiterstreifen 17 hin. Die Oxidationsrichtung 16 ist somit auch vorwiegend parallel zu den Bruchkanten 14 für die nachfolgende Vereinzelung. Der Vorteil dieses Verfahrens liegt darin, daß die partielle laterale Oxidation im Waferverbund erfolgen kann und damit der Herstellungsaufwand reduziert wird.

Bei der partiellen lateralen Oxidation nach der Vereinzelung, Figur 4b, wachsen die Oxidbereiche 15 vor allem senkrecht zu den Bruchkanten bzw. Spaltflächen. Damit bildet sich entlang der Bruchflächen ein durchgehender Oxidstreifen 15 gleicher Dicke. Die Dicke des Oxidstreifens 15 ist durch die Dauer des Oxidationsschritts einstellbar. Dieses Verfahren ist besonders vorteilhaft für Halbleiterlaser mit großer lateraler Ausdehnung wie beispielsweise Breitstreifenlaser oder Laserarrays.

Die Erläuterung der Erfindung anhand der beschriebenen Ausführungsbeispiele ist selbstverständlich nicht als Beschränkung der Erfindung hierauf zu verstehen. Insbesondere bezieht sich die Erfindung neben Laseroszillatoren auch auf Laserverstärker und Superstrahler, wobei in diesem Fall der Halbleiterkörper höchstens eine Spiegelschicht aufweist. Die anderen der Strahlungsauskopplung dienenden Grenzflächen des Halbleiterkörpers können mit einer geeigneten Vergütung, beispielsweise einer Entspiegelung, versehen sein.

## Patentansprüche

1. Halbleiterlaser mit einem Halbleiterkörper (1) mit einer ersten Hauptfläche, einer zweiten Hauptfläche, einer Resonatorachse (18) und einer zur Resonatorachse (18) parallelen aktiven Schicht (4), die zwischen der ersten und der zweiten Hauptfläche angeordnet ist, sowie einer ersten Spiegelfläche (6) und einer zweiten Spiegelfläche (7), die im wesentlichen senkrecht zur Resonatorachse (18) angeordnet sind, wobei im Halbleiterkörper (1) mindestens eine Stromführungsschicht (5) ausgebildet ist, die mindestens einen streifenförmigen, quer zur Resonatorachse (18) verlaufenden Widerstandsbereich (8,9) aufweist, dessen spezifischer Flächenwiderstand gegenüber den an den Widerstandsbereich (8,9) angrenzenden Bereichen der Stromführungsschicht (5) zumindest in Teilbereichen erhöht ist,
**dadurch gekennzeichnet, daß**
der spezifische Flächenwiderstand des mindestens einen Widerstandsbereichs (8,9) in einem ersten Teilbereich geringer ist als in einem zweiten Teilbereich, wobei der erste Teilbereich einen geringeren Abstand zur Resonatorachse (18) aufweist als der zweite Teilbereich.

2. Halbleiterlaser nach Anspruch 1,
**dadurch gekennzeichnet , daß**
an einer der beiden Spiegelflächen angrenzend ein Widerstandsbereich (8) ausgebildet ist.

3. Halbleiterlaser nach Anspruch 1,
**dadurch gekennzeichnet, daß**
an beiden Spiegelflächen je ein Widerstandsbereich (8) angrenzend ausgebildet ist.

4. Halbleiterlaser nach einem der Ansprüche 1 bis 3,
**dadurch gekennzeichnet , daß**
der mindestens eine Widerstandbereich (8,9) insgesamt oder in Teilbereichen elektrisch isolierend ist.

5. Halbleiterlaser nach einem der Ansprüche 1 bis 4,
**dadurch gekennzeichnet, daß**
auf der ersten Hauptfläche eine erste Kontaktfläche (2) ausgebildet ist.

6. Halbleiterlaser nach einem der Ansprüche 1 bis 5,
**dadurch gekennzeichnet , daß**
auf der zweiten Hauptfläche eine zweite Kontaktfläche (3) ausgebildet ist.

7. Halbleiterlaser nach einem der Ansprüche 1 bis 6,
**dadurch gekennzeichnet , daß**
die Stromführungsschicht (5), benachbart zur aktiven Schicht(4) angeordnet ist.

8. Halbleiterlaser nach einem der Ansprüche 1 bis 7,
**dadurch gekennzeichnet, daß**
der mindestens eine Widerstandbereich (8,9) ein Oxid des Materials der Stromführungsschicht (5) enthält.

9. Halbleiterlaser nach einem der Ansprüche 1 bis 8,
**dadurch gekennzeichnet , daß**
als Halbleitermaterial ein auf GaAs oder InP basierendes Material, insbesondere InGaAs, AlGaAs, InGaAlAs, InGaP, InGaAsP oder InGaAlP verwendet wird.

10. Herstellungsverfahren für einen Halbleiterlaser nach einem der Ansprüche 1 bis 9,
**gekennzeichnet durch** die Schritte
- Herstellung eines Halbleiterschichtsystems (11),
- Strukturierung des Halbleiterschichtsystems (11) in kammartige Halbleiterstreifen (17),
- partielle laterale Oxidation der Stromführungsschicht (5) zur Ausbildung von mindestens einem Widerstandsbereich (8,9),
- Ausbildung des mindestens einen Widerstandsbereichs (8,9) so, dass der spezifische Flächenwiderstand in einem ersten Teilbereich geringer ist als in einem zweiten Teilbereich und der erste Teilbereich einen geringeren Abstand zur Resonatorachse (18) aufweist als der zweite Teilbereich,
- Vereinzelung der Halbleiterstreifen (17) in Halbleiterkörper (1).

11. Verfahren nach Anspruch 10,
**dadurch gekennzeichnet , daß**
die Vereinzelung durch Brechen erfolgt.

12. Verfahren nach Anspruch 11,
**dadurch gekennzeichnet , daß**
jeweils eine Bruchkante (14) durch einen oxidierten Bereich (15) verläuft.

13. Verfahren nach einem der Ansprüche 10 bis 12,
**dadurch gekennzeichnet , daß**
die Vereinzelung nach der partiellen Oxidation erfolgt.

14. Verfahren nach einem der Ansprüche 10 bis 12,
**dadurch gekennzeichnet, daß**
die Vereinzelung vor der partiellen Oxidation erfolgt.

15. Verfahren nach einem der Ansprüche 10 bis 14,
**dadurch gekennzeichnet, daß**
das Verfahren fortgesetzt wird mit der Ausbildung der Kontaktflächen (2,3) auf den Hauptflächen des Halbleiterkörpers (1) .

16. Verfahren nach einem der Ansprüche 10 bis 15,
**dadurch gekennzeichnet , daß**
das Verfahren fortgesetzt wird mit einer optischen Vergütung der Spiegelflächen (6,7).

## Claims

1. Semiconductor laser with a semiconductor body (1) with a first main area, a second main area, a resonator axis (18) and an active layer (4), which is parallel to the resonator axis (18) and is arranged between the first and second main area, and also a first mirror area (6) and a second mirror area (7), which are arranged essentially perpendicularly to the resonator axis (18), at least one current-guiding layer (5) being formed in the semiconductor body (1), which layer has at least one strip-type resistance region (8, 9), which runs transversely with respect to the resonator axis (18) and whose sheet resistivity is increased at least in partial regions compared with the regions of the current-guiding layer (5) which adjoin the resistance region (8, 9),
**characterized in that**
the sheet resistivity of the at least one resistance region (8, 9) is lower in a first partial region than in a second partial region, the first partial region being at a shorter distance from the resonator axis (18) than the second partial region.

2. Semiconductor laser according to Claim 1,
**characterized in that**
a resistance region (8) is formed in a manner adjoining one of the two mirror areas.

3. Semiconductor laser according to Claim 1,
**characterized in that**
a respective resistance region (8) is formed in a manner adjoining both mirror areas.

4. Semiconductor laser according to one of Claims 1 to 3,
**characterized in that**
the at least one resistance region (8, 9) is electrically insulating in its entirety or in partial regions.

5. Semiconductor laser according to one of Claims 1 to 4,
**characterized in that**
a first contact area (2) is formed on the first main area.

6. Semiconductor laser according to one of Claims 1 to 5,
**characterized in that**
a second contact area (3) is formed on the second main area.

7. Semiconductor laser according to one of Claims 1 to 6,
**characterized in that**
the current-guiding layer (5) is arranged adjacent to the active layer (4).

8. Semiconductor laser according to one of Claims 1 to 7,
**characterized in that**
the at least one resistance region (8, 9) contains an oxide of the material of the current-guiding layer (5).

9. Semiconductor laser according to one of Claims 1 to 8,
**characterized in that**
a material based on GaAs or InP, in particular InGaAs, AlGaAs, InGaAlAs, InGaP, InGaAsP or InGaAIP, is used as semiconductor material.

10. Fabrication method for a semiconductor laser according to one of Claims 1 to 9,
**characterized by** the following steps:
- fabrication of a semiconductor layer system (11),
- patterning of the semiconductor layer system (11) into comb-like semiconductor strips (17),
- partial lateral oxidation of the current-guiding layer (5) in order to form at least one resistance region (8, 9),
- formation of the at least one resistance region (8, 9) such that the sheet resistivity is lower in a first partial region than in a second partial region and the first partial region is at a shorter distance from the resonator axis (18) than the second partial region,
- singulation of the semiconductor strips (17) into semiconductor bodies (1).

11. Method according to Claim 10,
**characterized in that**
the singulation is effected by breaking.

12. Method according to Claim 11,
**characterized in that**
a respective break edge (14) runs through an oxidized region (15).

13. Method according to one of Claims 10 to 12,
**characterized in that**
the singulation is effected after the partial oxidation.

14. Method according to one of Claims 10 to 12,
**characterized in that**
the singulation is effected before the partial oxidation.

15. Method according to one of Claims 10 to 14,
**characterized in that**
the method is continued with the formation of the contact areas (2, 3) on the main areas of the semiconductor body (1).

16. Method according to one of Claims 10 to 15,
**characterized in that**
the method is continued with an optical coating of the mirror areas (6, 7).

## Revendications

1. Laser à semi-conducteurs comprenant un corps (1) semi-conducteur ayant une première surface principale, une deuxième surface principale, un axe (18) de résonateur et une couche (4) active qui est parallèle à l'axe (18) du résonateur et qui est disposée entre la première et la deuxième surface principale, ainsi qu'une première surface (6) de miroir et une deuxième surface (7) de miroir qui sont disposées pour l'essentiel perpendiculaires à l'axe (18) du résonateur et dans lequel il est formé dans le corps (1) semi-conducteur au moins une couche (5) de passage du courant qui comporte au moins une partie (8, 9) résistive s'étendant sous forme de bande transversalement à l'axe (18) du résonateur et dont la résistance spécifique de surface est augmentée au moins dans des zones partielles par rapport aux zones de la couche (5) de passage du courant voisine de la zone (8, 9) de résistance,
**caractérisé en ce que**
la résistance spécifique de surface de la au moins une zone (8, 9) de résistance dans une première zone partielle est plus petite que dans une deuxième zone partielle, la première zone partielle ayant une distance plus petite à l'axe (18) du résonateur que la deuxième zone partielle.

2. Laser à semi-conducteurs suivant la revendication 1,
**caractérisé**
**en ce qu'**il est formé une zone (8) de résistance voisine de l'une des deux surfaces de miroir.

3. Laser à semi-conducteurs suivant la revendication 1,
**caractérisé**
**en ce qu'**il est formé, respectivement, une zone (8) de résistance voisine des deux surfaces de miroir.

4. Laser à semi-conducteurs suivant l'une des revendications 1 à 3,
**caractérisé**
**en ce que** la au moins une zone (8, 9) de résistance est dans l'ensemble ou dans des zones partielles isolante du point de vue électrique.

5. Laser à semi-conducteurs suivant l'une des revendications 1 à 4,
**caractérisé**
**en ce qu'**une première surface (2) de contact est formée sur la première surface principale.

6. Laser à semi-conducteurs suivant l'une des revendications 1 à 5,
**caractérisé**
**en ce qu'**une deuxième surface (3) de contact est formée sur la deuxième surface principale.

7. Laser à semi-conducteurs suivant l'une des revendications 1 à 6,
**caractérisé**
**en ce que** la couche (5) de passage du courant est disposée au voisinage de la couche (4) active.

8. Laser à semi-conducteurs suivant l'une des revendications 1 à 7,
**caractérisé**
**en ce que** la au moins une zone (8, 9) de résistance contient un oxyde du matériau de la couche (5) de passage du courant.

9. Laser à semi-conducteurs suivant l'une des revendications 1 à 8,
**caractérisé**
**en ce qu'**il est utilisé comme matériau semi-conducteur un matériau à base de GaAs ou de InP, notamment InGaAs, AlGaAs, InGaAlAs, InGaP, InGaAsP ou InGaAlP.

10. Procédé de production d'un laser à semi-conducteurs suivant l'une des revendications 1 à 9,
**caractérisé par** les stades dans lesquels :
- on produit un système (11) stratifié à semi-conducteurs ;
- on structure le système (11) stratifié à semi-conducteurs en des bandes (17) de semi-conducteurs en forme de peigne ;
- on oxyde latéralement partiellement la couche (5) de passage du courant pour constituer au moins une zone (8, 9) de résistance ;
- on forme la au moins une zone (8, 9) de résistance de façon à ce que la résistance spécifique de surface soit plus petite dans une première zone partielle que dans une deuxième zone partielle et la première zone partielle a une distance à l'axe (18) du résonateur plus petite que la deuxième zone partielle ;
- on individualise les bandes (17) semi-conductrices en des corps (1) semi-conducteurs.

11. Procédé suivant la revendication 10,
**caractérisé**
**en ce que** l'on effectue l'individualisation par cassure.

12. Procédé suivant la revendication 11,
**caractérisé**
**en ce que**, respectivement, une arête (14) de rupture s'étend dans une zone (15) oxydée.

13. Procédé suivant l'une des revendications 10 à 12,
**caractérisé**
**en ce que** l'on effectue l'individualisation après l'oxydation partielle.

14. Procédé suivant l'une des revendications 10 à 12,
**caractérisé**
**en ce que** l'on effectue l'individualisation avant l'oxydation partielle.

15. Procédé suivant l'une des revendications 10 à 14,
**caractérisé**
**en ce que** l'on poursuit le procédé par la formation des surfaces (2, 3) de contact sur les surfaces principales du corps (1) semi-conducteur.

16. Procédé suivant l'une des revendications 10 à 15,
**caractérisé**
**en ce que** l'on poursuit le procédé par un traitement optique des surfaces (6, 7) de miroir.
